# EUROPEAN PATENT APPLICATION

(11) **EP 4 844 417 A1**
(43) Date of publication of application: **25.11.2026**
(21) Application number: 25742306.1
(22) Date of filing: 16.01.2025
(51) Int. Cl.: G01R 27/02, G01R 19/00, G01R 31/52, G01R 31/392, G01R 31/389

(54) **APPARATUS AND METHOD FOR MEASURING RESISTANCE**

(30) Priority: 16.01.2024 KR 20240006726; 12.12.2024 KR 20240184775
(71) Applicant: LG Innotek Co., Ltd., Seoul 07796 (KR)
(72) Inventor: HU, Jun Young, Seoul 07796 (KR); CHO, Ig Hyun, Seoul 07796 (KR)
(74) Representative: DREISS Patentanwälte PartG mbB
(86) International application number: PCT/KR2025/099036
(87) International publication number: WO 2025/155158

(57) **Abstract**

Disclosed in an embodiment is a resistance measuring apparatus, comprising: a first switch connected to a positive terminal of a battery; a second switch connected to a negative terminal of the battery; a third switch connected between the first switch and the second switch; and a voltage measurement unit connected to the third switch.

## Description

### [Technical Field]

Embodiments relate to an insulation resistance measurement apparatus and method.

### [Background Art]

As research and development on electric vehicles, energy storage batteries, robots, and satellites has become increasingly active, research on high-performance batteries that can be repeatedly charged and discharged is also being actively conducted. Currently commercialized battery packs include rechargeable energy storage devices such as nickelcadmium batteries, nickel-hydrogen batteries, nickel-zinc batteries, and lithium-ion batteries.

In the case of a battery pack applied to a large electrical product requiring a high voltage, such as an electric vehicle, complete insulation between a battery pack and a vehicle body (that is, ground) needs to be maintained. When the insulation of a battery pack is not maintained, a leakage current may occur, and the leakage current may cause the discharge of a battery and the malfunctions and failure of electronic devices in which the battery is installed. In particular, when a leakage current occurs in high-voltage batteries such as those in electric or hybrid vehicles, the leakage current may cause fatal electric shock damage to a user. In order to eliminate such risks by more accurately determining the insulation degradation of a battery pack, there is a need for a method of more accurately and simply measuring an insulation resistance between a battery pack and a vehicle body.

### [Description of Invention]

### [Technical Problem]

Embodiments provide a resistance measurement apparatus and method which allows a configuration of an apparatus required for measuring an insulation resistance to be simplified.

In addition, provided is a resistance measurement apparatus and method which allows costs required for measuring an insulation resistance to be reduced.

Objects to be solved in the embodiments are not limited thereto, and the embodiments may also include objects or effects that can be understood from the solution or embodiment of the problem described below.

### [Technical Solution]

A resistance measurement apparatus according to an embodiment includes a first switch connected to a positive terminal of a battery, a second switch connected to a negative terminal of the battery, a third switch connected between the first switch and the second switch, and a voltage measurement unit connected to the third switch.

The resistance measurement apparatus according to the embodiment may include a first resistor connected between the positive terminal of the battery and the first switch, and a second resistor connected between the negative terminal of the battery and the second switch.

The resistance measurement apparatus according to the embodiment may include a third resistor connected between the third switch and the voltage measurement unit.

The voltage measurement unit may measure a voltage applied to the third resistor.

The resistance measurement apparatus according to the embodiment may include a reference voltage unit connected to the third resistor, and the reference voltage unit may be connected to ground.

The resistance measurement apparatus according to the embodiment may include a controller connected to the voltage measurement unit.

When the first switch and the third switch are turned on, the voltage measurement unit may measure a positive insulation resistance of the battery.

When the second switch and the third switch are turned on, the voltage measurement unit may measure a negative insulation resistance of the battery.

The controller may measure the positive insulation resistance or the negative insulation resistance according to the voltage measured by the voltage measurement unit.

The controller may determine that the battery is not insulated when the positive insulation resistance or the negative insulation resistance is less than a preset reference resistance value.

The controller may determine that the positive terminal or the negative terminal of the battery is not insulated when the positive insulation resistance or the negative insulation resistance is less than 1 mΩ.

The controller may generate a signal for turning the first to third switches on or off and transmit the generated signal to each of the first to third switches.

A resistance measurement method according to an embodiment includes turning a neutral switch on, turning a positive switch on, measuring a positive insulation resistance by a controller, turning the positive switch off, turning a negative switch on, measuring a negative insulation resistance by the controller, and turning the negative switch off, wherein the neutral switch may be connected between the positive switch and the negative switch.

### [Advantageous Effects]

According to embodiments, there can be provided a resistance measurement apparatus and method which allows a configuration of an apparatus required for measuring an insulation resistance to be simplified.

In addition, there can be provided a resistance measurement apparatus and method which allows costs required for measuring an insulation resistance to be reduced.

Various advantageous advantages and effects of the present invention are not limited to the above-described content and may be more readily understood in the course of describing a specific embodiment of the present invention.

### [Description of Drawings]

FIG. 1 is a diagram of a configuration of a resistance measurement apparatus according to an embodiment.
FIG. 2 is a block diagram for describing the resistance measurement apparatus according to the embodiment.
FIG. 3 is a circuit diagram of the resistance measurement apparatus according to an embodiment.
FIGS. 4 and 5 are exemplary diagrams illustrating a process of measuring an insulation resistance by the resistance measurement apparatus according to an embodiment.
FIG. 6 is a flowchart of a resistance measurement method according to an embodiment.

### [Modes of the Invention]

Hereinafter, exemplary embodiments of the present invention will be described with reference to the accompanying drawings.

However, the technical spirit of the present invention is not limited to the few embodiments which will be described and may be realized using various other embodiments, and at least one component of the embodiments may be selectively coupled, substituted, and used to realize the technical spirit within the range of the technical spirit of the present invention.

In addition, unless clearly and specifically defined otherwise by context, all terms (including technical and scientific terms) used herein may be interpreted as having customary meanings to those skilled in the art, and meanings of generally used terms, such as those defined in commonly used dictionaries, will be interpreted by considering contextual meanings of the related technology.

In addition, the terms used in the embodiments of the present invention are for the purpose of describing the embodiments and are not intended to limit the present invention.

In the present specification, unless clearly indicated otherwise by the context, singular forms include the plural forms thereof, and in a case in which "at least one (or one or more) of A, B, and C" is described, this may include at least one combination among all combinations which may be coupled to A, B, and C.

In addition, in descriptions of components of the present invention, terms such as "first," "second," "A," "B," "(a)," and "(b)" may be used.

Such terms are only to distinguish one element from another element, and an essence, order, and the like of the elements are not limited by the terms.

In addition, it should be understood that, when an element is referred to as being "connected or coupled" to another element, such a description may include both of a case in which the element is directly connected or coupled to the other element and a case in which the element is connected or coupled to the other element with still another element disposed therebetween.

In addition, in a case in which any one element is described as being formed or disposed "on or below" another element, such a description includes both cases in which the two elements are formed or disposed in direct contact with each other and in which one or more other elements are interposed between the two elements. In addition, when one element is described as being disposed "on or under" another element, such a description may include a case in which the one element is disposed at an upper side or a lower side with respect to the other element.

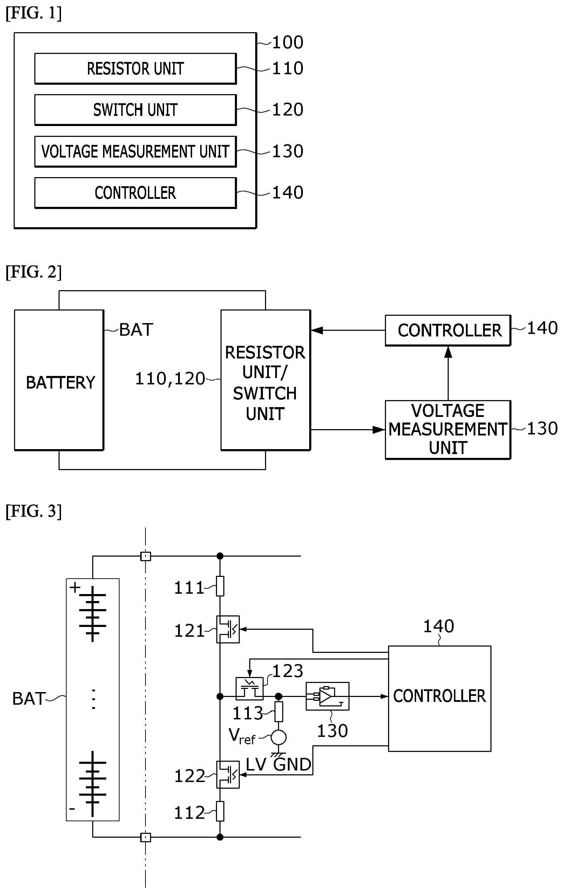

FIG. 1 is a diagram of a configuration of a resistance measurement apparatus according to an embodiment. FIG. 2 is a block diagram for describing the resistance measurement apparatus according to the embodiment. FIG. 3 is a circuit diagram of the resistance measurement apparatus according to an embodiment.

Referring to FIGS. 1 to 3, a resistance measurement apparatus 100 according to the embodiment may include a resistor unit 110, a switch unit 120, a voltage measurement unit 130, and a controller 140.

Each component may correspond to a sub-element constituting a battery management system (BMS) applied to a vehicle. Meanwhile, the term "battery" BAT described below may be a unit battery cell or a battery pack formed by stacking battery cells into a stack. The resistance measurement apparatus 100 may be electrically connected to the battery BAT. The resistance measurement apparatus 100 is electrically connected to a positive terminal of the battery BAT to measure an insulation of the battery BAT.

The resistor unit 110 may include first to third resistors 111, 112, and 113. The resistor unit 110 may be a resistor connected to a circuit such that the resistance measurement apparatus 100 measures an insulation resistance. The resistance measurement apparatus 100 may measure an insulation resistance by measuring a voltage applied to the resistor unit 110.

The first resistor 111 may be connected to the positive terminal (+) of the battery BAT. The first resistor 111 may be connected between the positive terminal (+) of the battery BAT and a first switch 121. The first resistor 111 may serve as a reference resistor for measuring a positive insulation resistance of the battery.

The second resistor 112 may be connected to a negative terminal (-) of the battery BAT. The second resistor 112 may be connected between the negative terminal (-) of the battery BAT and a second switch 122. The second resistor 112 may serve as a reference resistor for measuring a negative insulation resistance of the battery.

The third resistor 113 may be connected to ground GND. The third resistor 113 may be connected between the positive terminal (+) of the battery BAT and ground GND or between the negative terminal (-) of the battery BAT and ground GND. In addition, the third resistor 113 may be connected between a third switch 123 and ground GND. The resistance measurement apparatus 100 may measure an insulation resistance by measuring a voltage applied to the third resistor 113.

The switch unit 120 may include first to third switches 121, 122, and 123. The switch unit 120 may be disposed in a circuit to form a current path through on/off control. The switch unit 120 may be controlled to be turned on or off by the controller 140. The switch unit 120 may be turned on or off upon receiving a control signal from the controller 140. The switch unit 120 may be implemented using various elements capable of interrupting a current flow, such as a relay, a bipolar junction transistor (BJT), or a field-effect transistor (FET). For example, the switch unit 120 may include a PhotoMOS.

The first switch 121 may be connected to the positive terminal (+) of the battery BAT. In addition, the first switch 121 may be connected between the first resistor 111 and the third switch 123. The first switch 121 may be turned on or off upon receiving a control signal from the controller 140. The first switch 121 may be a positive switch. When a positive insulation resistance of the battery BAT is measured, the first switch 121 may be turned on.

The second switch 122 may be connected to the negative terminal (-) of the battery BAT. In addition, the second switch 122 may be connected between the second resistor 112 and the third switch 123. The second switch 122 may be turned on or off upon receiving a control signal from the controller 140. The second switch 122 may be a negative switch. When a negative insulation resistance of the battery BAT is measured, the second switch 122 may be turned on.

The third switch 123 may be disposed between the first switch 121 and the second switch 122. In addition, the third switch 123 may be connected to ground GND. The third resistor 113 and a reference voltage unit Vref may be connected between the third switch 123 and ground GND. The third switch 123 may be turned on or off upon receiving a control signal from the controller 140. The third switch 123 may be a neutral switch. The third switch 123 may be turned on both when a positive insulation resistance of the battery BAT is measured and when a negative insulation resistance is measured.

The voltage measurement unit 130 may measure a voltage. The voltage measurement unit 130 may measure a voltage applied to the third resistor 113. The voltage measurement unit 130 may measure a positive insulation resistance or negative insulation resistance by measuring a voltage applied to the second resistor 113. The voltage measurement unit 130 may be connected between the third resistor 113 and the controller 140. The voltage measurement unit 130 may transmit the measured voltage to the controller 140.

The controller 140 may control the turn-on/off of the switch unit. The controller 140 may generate a signal for turning the first to third switches 121, 122, and 123 on or off and transmit the generated signal to each of the first to third switches 121, 122, and 123. In addition, the controller 140 may receive voltage measurement information from the voltage measurement unit 130. The controller 140 may calculate a positive insulation resistance value or a negative insulation resistance value from a voltage value. The controller 140 may determine an insulation state of insulation resistance from an insulation resistance value. The controller 140 may determine that the battery is not insulated when the insulation resistance value is less than a preset reference resistance value. For example, the controller 140 may determine that the battery is not insulated when the measured insulation resistance value is less than 1 mΩ. The controller may include a microcontroller unit (MCU).

In addition, the resistance measurement apparatus 100 may include the reference voltage unit Vref connected to the third resistor 113. The reference voltage unit Vref may supply a DC voltage. The reference voltage unit Vref may supply a reference voltage for measuring a voltage applied to the third resistor 113. The reference voltage unit Vref may be connected to ground GND.

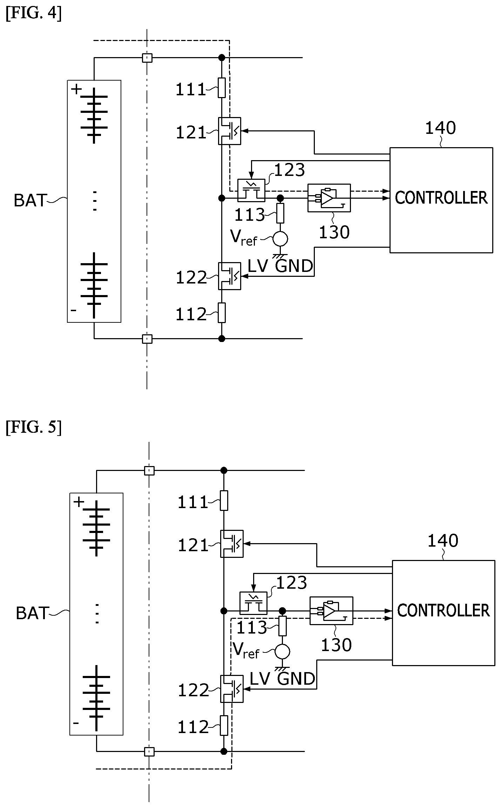

FIGS. 4 and 5 are exemplary diagrams illustrating a process of measuring an insulation resistance by the resistance measurement apparatus according to an embodiment.

Referring to FIGS. 4, when the resistance measurement apparatus measures a positive insulation resistance of the battery BAT, the first switch 121 and the third switch 123 may be turned on, and the second switch 122 may be turned off. When the first switch 121 and the third switch 123 are turned on, a current may flow through the first switch 121 and the third switch 123. Therefore, a current supplied from the positive terminal (+) of the battery BAT may pass through the first switch 121 via the first resistor 111 and pass through the third switch 123 to reach the third resistor 113. As a result, the voltage measurement unit 130 may be connected to the third resistor 113 to measure a voltage applied to the third resistor 113.

Referring to 5, when the resistance measurement apparatus measures a negative insulation resistance of the battery BAT, the second switch 122 and the third switch 123 may be turned on, and the first switch 121 may be turned off. When the second switch 122 and the third switch 123 are turned on, a current may flow through the second switch 122 and the third switch 123. Therefore, a current supplied from the reference voltage unit Vref may pass through the third switch 123 via the third resistor 113 and pass through the second switch 122 to reach the second resistor 112. As a result, the voltage measurement unit 130 may be connected to the third resistor 113 to measure a voltage applied to the third resistor 113.

The third switch 123 of the resistance measurement apparatus according to the embodiment may be turned on and used both when a positive insulation resistance is measured and when a negative insulation resistance is measured. Accordingly, since the resistance measurement apparatus includes the third switch 123, the number of switches required for measuring a resistance can be reduced, thereby simplifying a configuration of the apparatus required for measuring an insulation resistance and reducing costs required for measuring an insulation resistance.

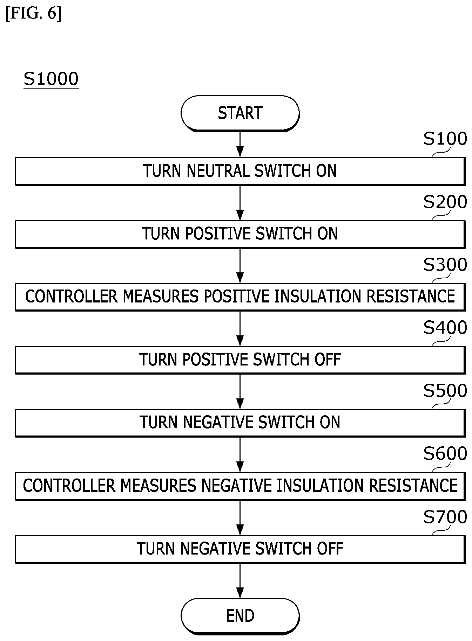

FIG. 6 is a flowchart of a resistance measurement method according to an embodiment.

Referring to FIG. 6, a resistance measurement method S1000 according to the embodiment may include operation S100 of turning a neutral switch on, operation S200 of turning a positive switch on, and operation S300 of measuring a positive insulation resistance by a controller. In addition, the resistance measurement method according to the embodiment may include operation S400 of turning the positive switch off, operation S500 of turning a negative switch on, operation S600 of measuring a negative insulation resistance by the controller, and operation S700 of turning the negative switch off.

In the resistance measurement method S1000, the positive insulation resistance may be measured in a state in which the neutral switch and the positive switch are turned on and the negative switch is turned off. In addition, in the resistance measurement method S1000, the negative insulation resistance may be measured in a state in which the neutral switch and the negative switch are turned on and the positive switch is turned off.

In the resistance measurement method according to the embodiment, the neutral switch may be turned on and used both when a positive insulation resistance is measured and when a negative insulation resistance is measured. Accordingly, by using the neutral switch in the resistance measurement method, the number of switches required for measuring a resistance can be reduced, thereby simplifying a configuration of the apparatus required for measuring an insulation resistance and reducing costs required for measuring an insulation resistance.

While the present invention has been described with reference to embodiments, this is merely an example and is not intended to limit the present invention, and those skilled in the art to which the present invention pertains will be able to understand that various modifications and applications not exemplified above are possible without departing from the essential characteristics of the present embodiment. For example, each component specifically shown in the embodiment may be implemented with modifications. In addition, differences related to the modifications and applications should be construed as being included in the scope of the present invention defined in the appended claims.

## Claims

1. A resistance measurement apparatus comprising:
a first switch connected to a positive terminal of a battery;
a second switch connected to a negative terminal of the battery;
a third switch connected between the first switch and the second switch; and
a voltage measurement unit connected to the third switch.

2. The resistance measurement apparatus of claim 1, comprising:
a first resistor connected between the positive terminal of the battery and the first switch; and
a second resistor connected between the negative terminal of the battery and the second switch.

3. The resistance measurement apparatus of claim 2, comprising a third resistor connected between the third switch and the voltage measurement unit.

4. The resistance measurement apparatus of claim 3, wherein the voltage measurement unit measures a voltage applied to the third resistor.

5. The resistance measurement apparatus of claim 4, comprising a reference voltage unit connected to the third resistor,
wherein the reference voltage unit is connected to ground.

6. The resistance measurement apparatus of claim 5, comprising a controller connected to the voltage measurement unit.

7. The resistance measurement apparatus of claim 6, wherein, when the first switch and the third switch are turned on, the voltage measurement unit measures a positive insulation resistance of the battery.

8. The resistance measurement apparatus of claim 6, wherein, when the second switch and the third switch are turned on, the voltage measurement unit measures a negative insulation resistance of the battery.

9. The resistance measurement apparatus of claim 7 or 8, wherein the controller measures the positive insulation resistance or the negative insulation resistance according to the voltage measured by the voltage measurement unit.

10. The resistance measurement apparatus of claim 9, wherein the controller determines that the battery is not insulated when the positive insulation resistance or the negative insulation resistance is less than a preset reference resistance value.
